(19) Europäisches Patentamt
European Patent Office
Office européen des brevets

(11) **EP 1 775 807 A2**

(12) **DEMANDE DE BREVET EUROPEEN**

(43) Date de publication:
**18.04.2007 Bulletin 2007/16**

(51) Int Cl.:
*H01S 5/50* *(2006.01)* *H01S 5/34* *(2006.01)*
*H01S 5/12* *(2006.01)*

(21) Numéro de dépôt: **06121844.2**

(22) Date de dépôt: **05.10.2006**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(30) Priorité: **14.10.2005 FR 0510512**

(71) Demandeur: **Alcatel Lucent**
**75008 Paris (FR)**

(72) Inventeur: **Dagens, Béatrice**
**92160 Antony (FR)**

(74) Mandataire: **Bréda, Jean-Marc et al**
**Marks & Clerk France**
**31-33, Avenue Aristide Briand**
**94117 Arcueil Cedex (FR)**

(54) **Dispositif optique à semiconducteur à densité de porteurs verrouillée**

(57)    Le domaine de l'invention est celui des dispositifs à semi-conducteur utilisés soit pour l'amplification, soit pour la modulation de phase de signaux optiques. Ces dispositifs sont connus sous les termes génériques de SOA, acronyme anglo-saxon signifiant Semiconductor Optical Amplifier et de modulateurs DPSK, acronyme anglo-saxon signifiant Differential Phase Shift Keying.

Les inconvénients principaux de ce type de dispositif sont qu'il est, d'une part difficile d'obtenir un gain constant et d'autre part, qu'il est difficile de moduler indépendamment le signal optique en amplitude et en phase.

Le dispositif selon l'invention ne présente pas ces inconvénients. Il repose essentiellement sur 3 principes :
• La zone active (1) du dispositif comporte une structure à îlots quantiques, les atomes de ladite structure possédant un premier état de transition d'énergie dit état fondamental et un second état de transition d'énergie dit état excité ;
• La zone active est disposée dans une cavité résonante structurée pour résonner à une première longueur d'onde correspondant à l'état fondamental ;
• Le courant traversant la zone active est supérieur au courant de saturation de l'état fondamental afin de permettre l'oscillation à une seconde longueur d'onde correspondant à l'état excité.

FIG. 9

## Description

Le domaine de l'invention est celui des dispositifs à semi-conducteur utilisés soit pour l'amplification, soit pour la modulation de phase de signaux optiques. Les dispositifs utilisés pour l'amplification sont connus sous le terme générique de SOA, acronyme anglo-saxon signifiant Semiconductor Optical Amplifier.

Les dispositifs à semi-conducteur actuels utilisés pour l'amplification ou pour la modulation de signaux optiques présentent plusieurs inconvénients.

D'une part, les variations de gain optique du milieu actif sont intrinsèquement liées aux variations de son indice optique, les variations de gain entraînant des variations d'amplitude des signaux optiques et les variations d'indice optique entraînant des variations de phase. Dans ces conditions, il est impossible d'obtenir un signal qui soit modulé indépendamment en amplitude ou en phase. Ce phénomène peut dégrader de façon sensible les performances d'un modulateur optique de type DPSK ou DQPSK.

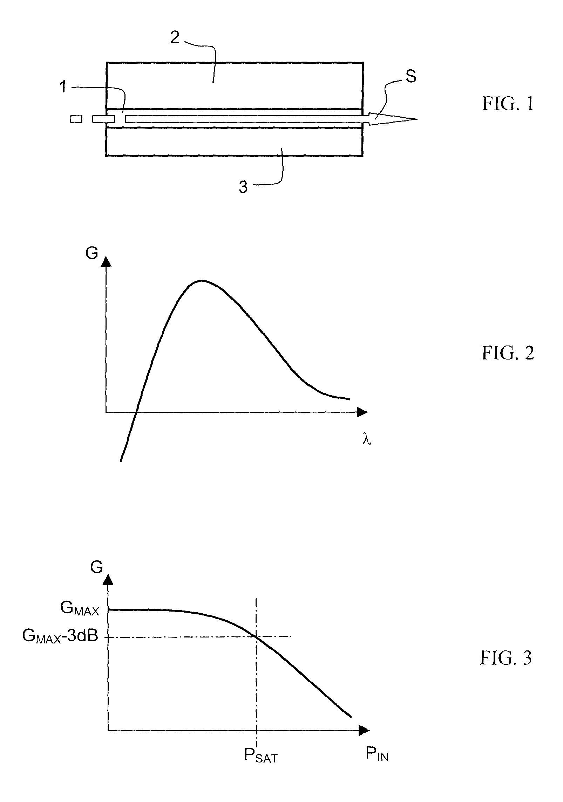

D'autre part, les dispositifs d'amplification optique présentent un inconvénient important. Il est difficile de maintenir un gain constant lorsque la puissance du signal optique devient trop importante. Les figures 1, 2 et 3 illustrent ce principe. La figure 1 représente le schéma d'un amplificateur comportant une zone active 1 dans laquelle circule le signal optique S à amplifier, symbolisé par une flèche droite rayée. Classiquement, cette zone active 1 est comprise entre deux couches 2 et 3 de semiconducteurs dopés n et p. La figure 2 représente la variation du gain d'amplification G de cet amplificateur en fonction de la longueur d'onde $\lambda$. Le gain passe par un maximum pour une certaine longueur d'onde et un certain courant. La figure 3 représente la variation du gain G en fonction de la puissance optique initiale $P_{IN}$ du signal optique incident sur l'amplificateur. Au-delà d'une certaine puissance optique dite puissance à saturation $P_{SAT}$, le gain diminue rapidement. Généralement, $P_{SAT}$ est la puissance correspondant à un gain égal au gain maximal $G_{MAx}$ diminué de 3dB.

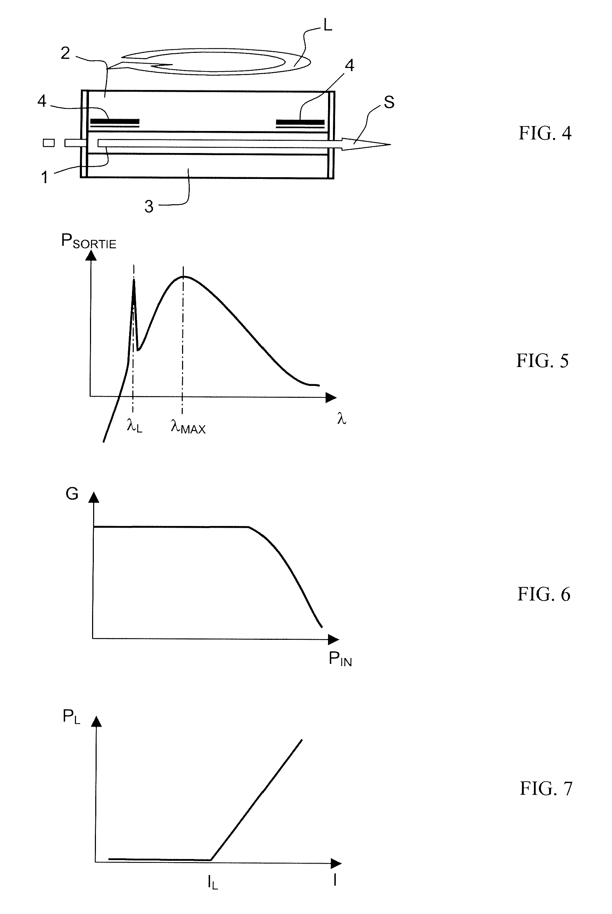

Pour pallier cet inconvénient, on utilise des SOA dits à gain verrouillé, encore appelé CG-SOA, acronyme anglo-saxon signifiant « Clamped-Gain Semiconductor Optical Amplifier ». Les figures 4, 5, 6 et 7 illustrent ce principe. La figure 4 représente le schéma d'un amplificateur CG-SOA. Il comprend classiquement une zone active 1 comprise entre deux couches de semi-conducteurs 2 et 3. Les parties extrêmes de la structure comporte un traitement optique 4 qui les rend réfléchissantes à une longueur d'onde donnée $\lambda_L$, ce traitement est symbolisé par un double trait horizontal sur la figure 4. Ce traitement est généralement un réseau de Bragg. La structure forme ainsi une cavité optique dans laquelle un rayonnement optique est susceptible de laser. Lorsque l'intensité du courant circulant dans la zone active est suffisant, un rayonnement laser se produit à la longueur d'onde $\lambda_L$. Le rayonnement laser L circulant à l'intérieur de la cavité est symbolisé par une flèche en arc fermé disposé au-dessus de la structure. Dans ce cas, pour une puissance d'entrée donnée, la puissance de sortie $P_{SORTIE}$ en fonction de la longueur d'onde $\lambda$ a la forme représentée en figure 5. Elle possède un pic de puissance à la longueur d'onde laser $\lambda_L$. Les signaux ayant des longueurs d'onde proches de cette longueur d'onde $\lambda_L$ peuvent difficilement être amplifiés. On estime la largeur totale de cette zone aveugle centrée sur la longueur d'onde de laser $\lambda_L$ à environ 10 nanomètres.

En ajustant le traitement optique et les paramètres géométriques de la cavité, il est facile de positionner la longueur d'onde $\lambda_L$ de façon qu'elle se trouve en dehors de la zone de gain maximal centrée sur la longueur d'onde $\lambda_{MAX}$. On sait alors, qu'à l'intérieur de la cavité laser, quelque soit la puissance émise par le laser, le gain du milieu amplificateur équilibre les pertes dues à la cavité. Ainsi, le nombre de porteurs de charges reste constant. Par conséquent, on maintient, en première approximation et comme indiqué sur la figure 6, un gain G quasiment constant pour tout signal optique ayant une puissance optique initiale $P_{IN}$ traversant le milieu amplificateur.

Cependant, les dispositifs de type CG-SOA présentent encore certains inconvénients. En effet, comme le montre la figure 7, dès que l'intensité dépasse un courant de seuil $I_L$, la puissance de sortie du laser $P_L$ croît avec l'intensité du courant I traversant la zone active de l'amplificateur. Par conséquent, la puissance laser n'est pas constante. Or, on démontre que le gain dépend au second ordre de la puissance laser. On a, en effet, la relation :

$$G = \frac{G_0}{1 + \varepsilon.P_{LASER}}$$

avec $G_0$ égal à une première constante et $\varepsilon$ égal à une seconde constante, appelée facteur de compression du gain.

On démontre également que, si plusieurs canaux optiques modulés à des longueurs d'onde différentes sont amplifiés simultanément, des phénomènes d'interférence ou de diaphonie peuvent se produire entre canaux. Ce phénomène introduit cependant des perturbations assez faibles.

L'ensemble de ces inconvénients est essentiellement dû au fait que la puissance du laser reste dépendante de l'intensité du courant injecté dans la zone active. L'objet de l'invention est de réaliser une structure où, au-delà d'un certain seuil de courant, la puissance du laser de sortie devient sensiblement constante. On supprime ainsi en grande partie les difficultés précédentes.

Plus précisément, l'invention a pour objet un dispositif optique à semi-conducteur commandé par un générateur de courant, ledit dispositif comprenant au moins une zone active comportant une structure à îlots quantiques, les atomes de ladite structure possédant un premier état de transition d'énergie dit état fondamental et un second état de transition d'énergie dit état excité, caractérisé en ce que la zone active est disposée dans une cavité résonante structurée pour résonner à une première longueur d'onde correspondant à l'état fondamental, le générateur de courant délivrant un courant supérieur au courant de saturation de l'état fondamental.

Avantageusement, la cavité optique peut être de type DFB, acronyme anglo-saxon signifiant « Distributed FeedBack » ou de type DBR, acronyme anglo-saxon signifiant « Distributed Bragg Reflector ».

Avantageusement, le dispositif peut être de type amplificateur optique à semi-conducteur, destiné à amplifier un signal optique d'amplitude variable ayant une longueur d'onde supérieure à la première longueur d'onde, le courant délivré par le générateur de courant étant sensiblement constant.

Avantageusement, le dispositif peut être aussi de type modulateur de phase, destiné à moduler en phase un signal optique d'amplitude constante ayant une longueur d'onde supérieure à la première longueur d'onde, le courant délivré par le générateur de courant étant modulé en intensité entre une valeur minimale et une valeur maximale, la valeur minimale étant supérieure au courant de saturation de l'état fondamental.

Avantageusement, la structure à îlots quantiques est réalisée sur des couches en InGaAsP et les îlots quantiques sont réalisés en InAs ou en InAs/InP ou en InAs/AsGa.

L'invention sera mieux comprise et d'autres avantages apparaîtront à la lecture de la description qui va suivre donnée à titre non limitatif et grâce aux figures annexées parmi lesquelles :

- La figure 1 représente le schéma d'un amplificateur SOA selon l'art antérieur ;
- La figure 2 représente la courbe de gain en fonction de la longueur d'onde dudit amplificateur SOA ;
- La figure 3 représente la courbe de gain du SOA en fonction de la puissance initiale du signal incident ;
- La figure 4 représente le schéma d'un amplificateur CG-SOA dit à gain verrouillé ;
- La figure 5 représente la puissance de sortie en fonction de la longueur d'onde dudit amplificateur CG-SOA ;
- La figure 6 représente la courbe de gain du CG-SOA en fonction de la puissance initiale du signal incident ;
- La figure 7 représente la puissance de sortie du laser du CG-SOA en fonction du courant injecté dans la zone active ;
- La figure 8 représente les niveaux de transition d'énergie dans une structure à îlots quantiques ;
- La figure 9 représente la puissance de sortie du laser du CG-SOA en fonction du courant injecté dans la zone active ;
- La figure 10 représente le schéma d'un amplificateur CG-SOA selon l'invention ;
- La figure 11 représente la courbe de gain en fonction de la longueur d'onde d'un amplificateur CG-SOA selon l'invention ;
- La figure 12 représente la courbe de gain du CG-SOA selon l'invention en fonction de la puissance initiale du signal incident ;
- La figure 13 représente la variation du courant injecté en fonction du temps dans un modulateur optique de type DPSK selon l'invention ;
- La figure 14 représente les variations d'intensité d'un signal optique traversant ledit modulateur ;
- La figure 15 représente les variations de phase dudit signal optique.

Les îlots quantiques appelés encore « Quantum Dots » en terminologie anglo-saxonne sont des micro-structures qui comportent une quantité réduite de porteurs de charges, trous ou électrons libres. Elles sont fabriquées dans des matériaux de type semi-conducteur et ont des dimensions comprises entre quelques nanomètres et quelques dizaines de nanomètres dans les trois dimensions de l'espace. La taille et la forme de ces structures et donc le nombre d'électrons qu'elles contiennent, peuvent ainsi être précisément contrôlées. Comme dans un atome, les niveaux d'énergie dans un îlot quantique sont quantifiés, ce qui rend ces structures particulièrement intéressantes pour un grand nombre d'applications physiques.

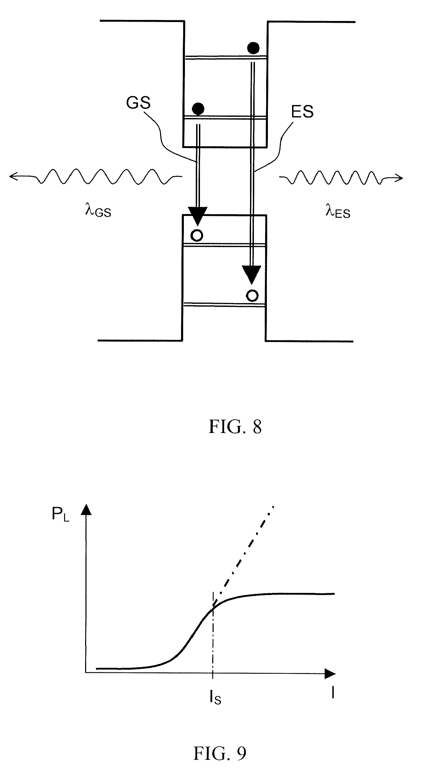

Comme le montre la figure 8, il peut exister uniquement deux états de transition possibles d'énergie dans une structure à îlots quantiques appelés état fondamental ou encore GS, acronyme anglo-saxon signifiant « Ground State » et état excité ou encore ES, acronyme anglo-saxon signifiant « Excited State », l'état fondamental correspondant au plus bas niveau d'énergie. Ces deux états de transition correspondent aux deux flèches verticales de la figure 8. A ces deux états de transition, correspondent deux longueurs d'onde d'émission que l'on notera $\lambda_{ES}$ et $\lambda_{GS}$. Comme il a été dit, le nombre de porteurs correspondant à une transition possible est fini et peut être aisément atteint. Lorsque les niveaux d'énergie correspondant à l'état fondamental sont remplis, alors les transitions possibles ne peuvent plus correspondre qu'au niveau d'énergie plus élevé, c'est-à-dire à l'état excité.

Ainsi, comme illustré en figure 9, dans une structure de type CG-SOA dont la zone active est à puits quantiques, lorsque cette structure est soumise à un courant I de porteurs de charges, le laser émet une puissance $P_L$ d'abord à la longueur d'onde correspondant à l'état fondamental à la longueur d'onde $\lambda_{GS}$, courbe en traits pleins de la figure 9. La puissance $P_L$ émise par le laser varie d'abord linéairement jusqu'à une certaine valeur du courant $I_s$ appelée courant à saturation. Au-delà de cette valeur, les niveaux d'énergie correspondant à l'état fondamental étant remplis, la puissance $P_L$ émise par le laser reste constante à cette longueur d'onde $\lambda_{GS}$. La

structure peut alors émettre à la longueur d'onde $\lambda_{ES}$, correspondant à l'état de transition excité. A la longueur d'onde $\lambda_{ES}$, la structure devient transparente. Cela signifie que lorsqu'un signal optique à cette longueur d'onde $\lambda_{ES}$ traverse la structure , il subit un gain égal ou supérieur aux pertes par absorption. Si la structure est disposée dans une cavité et si le gain est suffisant pour compenser également les pertes optiques de la cavité, alors la structure peut émettre un rayonnement laser à la longueur d'onde $\lambda_{ES}$. La puissance émise à cette longueur d'onde est tracée en traits pointillés sur la figure 9.

Par conséquent, pour obtenir un gain constant dans un dispositif optique à semi-conducteur commandé par un générateur de courant possédant une zone active, il est nécessaire que trois conditions soient remplies :

- La zone active doit comporter une structure à îlots quantiques, les atomes de ladite structure possédant un premier état de transition d'énergie dit état fondamental et un second état de transition d'énergie dit état excité ;
- La zone active doit être disposée dans une cavité résonante structurée pour résonner à une première longueur d'onde correspondant à l'état fondamental ;
- le générateur de courant doit délivrer un courant supérieur au courant de saturation de l'état fondamental pour verrouiller la puissance de sortie de l'état fondamental et assurer la transparence à une seconde longueur d'onde correspondant à l'état excité.

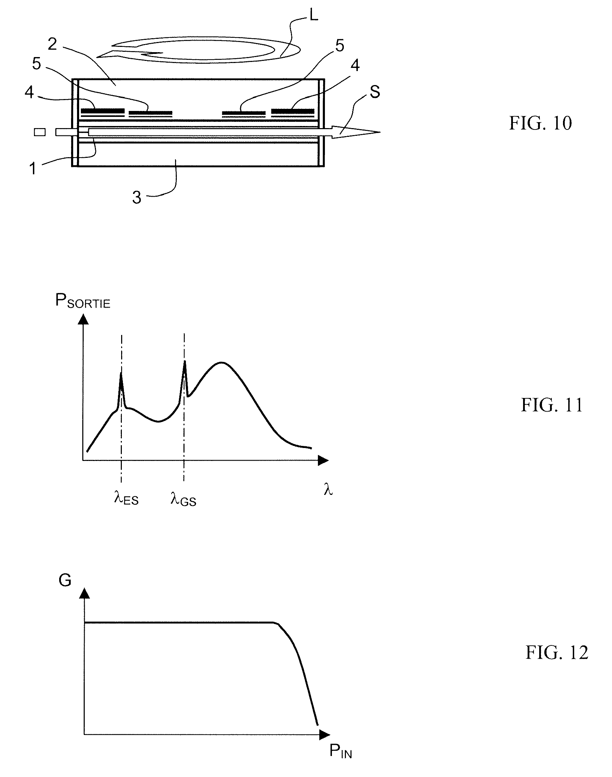

Une telle structure est représentée en figure 10. Elle comporte essentiellement une zone active 1 comprise entre deux couches 2 et 3 de semi-conducteurs dopés. La zone active 1 comporte au moins une structure à îlots quantiques. Les parties extrêmes de la structure comporte un traitement optique 4 qui les rend réfléchissantes à la longueur d'onde $\lambda_{GS}$, ce traitement est symbolisé par un double trait horizontal sur la figure 10. La structure forme ainsi une cavité optique dans laquelle un rayonnement optique est susceptible de laser à cette longueur d'onde. La cavité peut également comporter un second traitement réfléchissant 5 à la longueur d'onde $\lambda_{ES}$ afin qu'un rayonnement optique puisse également osciller à cette longueur d'onde $\lambda_{ES}$. Le rayonnement laser L circulant à l'intérieur de la cavité est symbolisé par une flèche en arc fermé.

Dans ces conditions, pour une puissance d'entrée donnée, la puissance de sortie $P_{SORTIE}$ en fonction de la longueur d'onde $\lambda$ a la forme représentée en figure 11. Elle possède deux pics de gain aux longueurs d'onde laser $\lambda_{GS}$ et $\lambda_{ES}$. La longueur d'onde du signal optique $\lambda_S$ traversant la structure doit alors être supérieure à $\lambda_{GS}$ comme indiqué sur la figure 11.

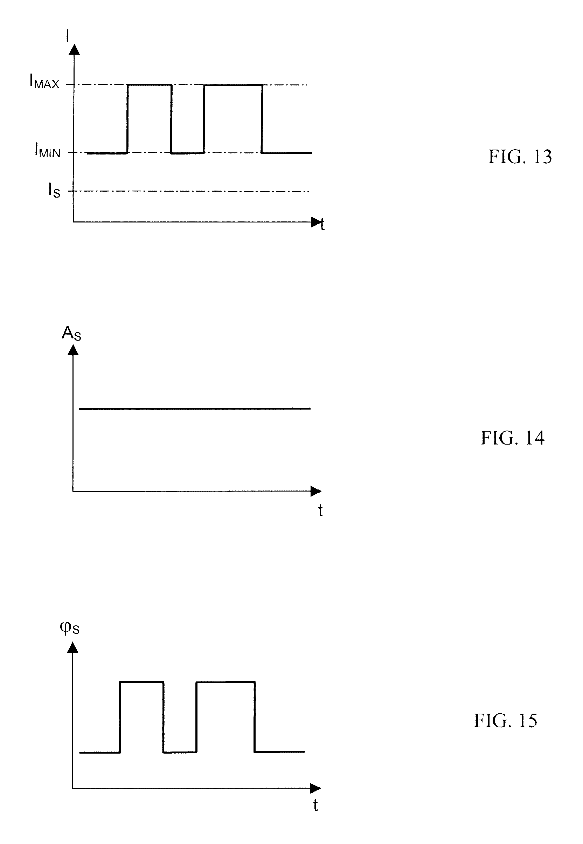

On maintient alors, comme indiqué sur la figure 12, un gain constant pour tout signal optique ayant une puissance initiale $P_{IN}$ traversant le milieu amplificateur à la condition que sa longueur d'onde soit supérieure à $\lambda_{GS}$.

Ce type de structure a deux applications principales.

Dans une première application, le dispositif est de type amplificateur optique à semi-conducteur. Il est destiné à amplifier un signal optique d'amplitude variable ayant une longueur d'onde supérieure à la première longueur d'onde $\lambda_{GS}$. Le courant délivré par le générateur de courant doit délivrer un courant supérieur au courant de saturation de l'état fondamental et être sensiblement constant. On obtient ainsi un gain d'amplification constant.

Dans une seconde application, le dispositif est de type modulateur de phase, destiné à moduler en phase un signal optique d'amplitude constante ayant une longueur d'onde supérieure à la première longueur d'onde. Les modulateurs de phase peuvent être de type PSK, acronyme anglo-saxon signifiant « Phase Shift Keying ». Les modulateurs de type PSK fonctionnent par déplacement de phase. Ainsi, le niveau logique 0 est codé par une phase de référence égale à 0 et le niveau logique 1 est codé par une phase de référence égale à 180 degrés. Ils existent des variantes de type DPSK ou DQPSK, acronymes anglo-saxons signifiant « Differential Phase Shift Keying » et « Differential Quadrature Phase Shift Keying ».

Comme illustré en figure 13, le courant I délivré par le générateur de courant est alors modulé en intensité en fonction du temps t entre une valeur minimale $I_{MIN}$ et une valeur maximale $I_{MAX}$, la valeur minimale étant supérieure au courant de saturation $I_S$ de l'état fondamental. Dans ces conditions, le gain d'amplitude du modulateur reste constant malgré les modulations d'intensité du courant. L'amplitude $A_S$ d'un signal de sortie reste constante comme illustré en figure 14. A contrario, les modulations d'intensité du courant entraînent une modulation du nombre de porteurs appartenant à l'état de transition d'énergie dit état excité, cette modulation entraîne une modulation de l'indice optique de la zone active. Et, cette modulation d'indice entraîne une modulation de la phase $\varphi_S$ du signal optique de sortie comme illustré en figure 15. Ainsi, il est possible de générer des signaux optiques possédant des modulations de phase pures, sans modulations d'intensité parasites.

La réalisation de structures à îlots quantiques ne pose pas de problèmes particuliers. La couche active à îlots quantiques peut être réalisée sur des couches en InGaAsP. Les îlots quantiques peuvent être réalisés en InAs ou en InAs/InP ou en InAs/AsGa. Il faut, bien entendu, respecter les compatibilités nécessaires entre les matériaux des couches supports et ceux des îlots quantiques proprement dits.

**Revendications**

**1.** Amplificateur optique à semi-conducteur destiné à amplifier un signal optique (S) d'amplitude variable, ledit amplificateur commandé par un générateur de courant et comprenant au moins une zone active (1) comportant une structure à îlots quantiques, les atomes de ladite structure possédant un premier état de transition d'énergie dit état fondamental (GS) et un second état de transition d'énergie dit état excité (ES), **caractérisé en ce que** la zone active est disposée dans une cavité résonante structurée pour résonner à une première longueur d'onde ($\lambda_{GS}$) correspondant à l'état fondamental, le générateur de courant délivrant un courant (I) supérieur au courant de saturation $I_S$ de l'état fondamental et sensiblement constant, le signal optique (S) ayant une longueur d'onde supérieure à la première longueur d'onde ($\lambda_{GS}$).

2. Modulateur de phase à semi-conducteur destiné à moduler en phase un signal optique (S) d'amplitude constante ($A_S$), ledit modulateur commandé par un générateur de courant et comprenant au moins une zone active (1) comportant une structure à îlots quantiques, les atomes de ladite structure possédant un premier état de transition d'énergie dit état fondamental (GS) et un second état de transition d'énergie dit état excité (ES), **caractérisé en ce que** la zone active est disposée dans une cavité résonante structurée pour résonner à une première longueur d'onde ($\lambda_{GS}$) correspondant à l'état fondamental, le courant délivré par le générateur de courant étant modulé en intensité entre une valeur minimale ($I_{MIN}$) et une valeur maximale ($I_{MAX}$), la valeur minimale étant supérieure au courant de saturation ($I_S$) de l'état fondamental, le signal optique (S) ayant une longueur d'onde supérieure à la première longueur d'onde ($\lambda_{GS}$).

3. Dispositif optique selon les revendications 1 ou 2, **caractérisé en ce que** la cavité est de type DFB ou de type DBR.

4. Dispositif optique selon l'une des revendications précédentes, **caractérisé en ce que** la structure à îlots quantiques est réalisée sur des couches en InGaAsP, les îlots quantiques étant réalisés en InAs ou en InAs/InP ou en InAs/AsGa.

FIG. 1

FIG. 2

FIG. 3

FIG. 4

FIG. 5

FIG. 6

FIG. 7

GS

ES

$\lambda_{GS}$

$\lambda_{ES}$

FIG. 8

$P_L$

$I_S$

$I$

FIG. 9

FIG. 10

FIG. 11

FIG. 12

FIG. 13

FIG. 14

FIG. 15